Europäisches Patentamt

(19) European Patent Office

Office européen des brevets

(11) Publication number: **0 073 603**
**B1**

(12) **EUROPEAN PATENT SPECIFICATION**

(45) Date of publication of patent specification: **26.08.87**

(21) Application number: **82304352.6**

(22) Date of filing: **18.08.82**

(51) Int. Cl.⁴: **H 01 L 27/12, H 01 L 27/15, H 01 L 29/04, H 01 L 29/78**

(54) Polycrystalline thin-film transistor,integrated circuit including such transistors and a display device including such a circuit.

(30) Priority: **19.08.81 JP 128757/81**
**28.07.82 JP 130324/82**

(43) Date of publication of application:
**09.03.83 Bulletin 83/10**

(45) Publication of the grant of the patent:
**26.08.87 Bulletin 87/35**

(84) Designated Contracting States:
**DE FR GB NL**

(56) References cited:
**EP-A-0 023 021**
**FR-A-1 538 001**

**THIN SOLID FILMS, vol. 2, nos. 1,2, July 1968, pages 57-78, Elsevier, Lausanne, CH; C.A. NEUGEBAUER et al.: "Polycrystalline CdS thin film field effect transistors: Fabrication, stability and temperature dependence"**

(73) Proprietor: **Hitachi, Ltd.**
**5-1, Marunouchi 1-chome**
**Chiyoda-ku Tokyo 100 (JP)**

(72) Inventor: **Matsui, Makoto**
**2-14-10 Kita**
**Kunitachi-shi Tokyo (JP)**
Inventor: **Shiraki, Yasuhiro**
**1-1-6-3-26-1 Hirayama**
**Hino-shi Tokyo (JP)**
Inventor: **Maruyama, Eiichi**
**1572-3 Josuihoncho**
**Kodaira-shi Tokyo (JP)**

(74) Representative: **Paget, Hugh Charles Edward et al**
**MEWBURN ELLIS & CO. 2/3 Cursitor Street London EC4A 1BQ (GB)**

# 0 073 603

**Description**

The present invention relates to a transistor the material of which is a polycrystalline semiconductor layer formed on an insulating body and further relates to a semiconductor integrated circuit including a plurality of such transistors and to a display device including such a circuit.

The transistor of the present invention is useful as, for example, a semiconductor device which is unitary with the displaying substrate of a flat display device, employing a liquid crystal, electroluminescence or the like and which is operated to drive the display device.

In a flat display device employing a liquid crystal, there has hitherto been adopted a system in which, on for example a single-crystal Si substrate, there is formed an integrated circuit in which a two-dimensional switching matrix of MOS transistors and peripheral scanning circuitry are unitary. The liquid crystal, which fills up the interspace between the single-crystal Si integrated circuit elements and counter electrodes, is driven by those circuit elements. Since the substrate is a single crystal, the size of the substrate which can be prepared is limited, and hence the size of the screen of the liquid-crystal flat display device is limited. By way of example, the diameter of a Si wafer which can be produced at present is at most 5 inches, so that a screen of a size corresponding to a cathode-ray tube larger than the 5-inch type cannot be fabricated. It is a serious disadvantage as a picture device that a large area cannot be attained.

To the end of eliminating this disadvantage, it has also been proposed that an amorphous semiconductor layer or a polycrystalline semiconductor layer is formed on an amorphous substrate, and integrated circuit elements as described above are formed using the material of this layer and are used to drive a flat display device. Since, in this case, the semiconductor layer may be formed on the amorphous substrate by a process such as vacuum evaporation, a large area in excess of a diameter of 5 inches can be attained, and the area of the flat display device can be made large.

However, the carrier mobility of the amorphous semiconductor layer is conspicuously low, and the characteristics of the transistors formed of it are inferior. On the other hand, in a polycrystalline semiconductor layer, the carrier mobility is high enough for use as the display device. However, if the grain size and the current path (channel) length of the element are approximately equal, the presence of a grain boundary leads to the disadvantage that the characteristics of the respective elements vary. More specifically, the current path of one element traverses the grain boundary, whereas the current path of another element does not, and the conduction of carriers is affected by the grain boundary in some elements and not in the others. As a result, the individual elements differ in their transistor characteristics, for example, the transconductance.

Examples of polycrystalline silicon devices, are described in the following references:

(1) Thin-Solid Films, vol. 35, June 1976, No. 2, pp. 149—153.
(2) Electrical Design News, vol. 18, No. 13, July 1973, pp. 30—31.
(3) IBM Technical Disclosure Bulletin, vol. 14, No. 10, March 1972, pp. 2900—2901.
(4) Applied Physics Letters, vol. 35, 15th July 1979, No. 2, pp. 173—175.
(5) IBM Technical Disclosure Bulletin, vol. 17, No. 8, January 1975, pp. 2455—2456.
(6) Solid State Electronics, vol. 15, No. 10, October 1972, pp. 1103—1106.

An object of the present invention is to eliminate or mitigate the disadvantages of the prior art described above and to provide a thin-film transistor having excellent and more uniform transistor characteristics.

The present invention is set out in the claims.

An embodiment of the invention will now be described by way of example with reference to the accompanying drawings, in which:—

Figure 1 is a graph showing the relationship between the thickness of an evaporated layer and the grain size;

Figures 2a—2h are sectional views showing a process for producing a MOSFET embodying the present invention, by the use of a polycrystalline semiconductor layer;

Figure 3 is a characteristic diagram of a MOSFET of an embodiment of the invention; and

Figure 4 is a graph showing the relationship between the mean grain size and the transconductance.

In the invention, a polycrystalline semiconductor layer is formed on a predetermined substrate and a semiconductor device is formed using the polycrystalline semiconductor layer. The length of a path in which carriers move (the channel length) is equal to or greater than 10 times the grain size (the longer diameter when a crystal grain is flat). In this specification, the term "grain size" signifies the "mean grain size". More specifically, the characteristics of the circuit elements depend upon the number of grain boundaries which the carriers encounter in the course of migration (travel). Since there are a sufficiently large number of crystal grains in the carriers path, each carrier is affected by a large number of grain boundaries. Therefore, when a large number of semiconductor devices are manufactured, their characteristics have a good uniformity. To minimize variation of the characteristics, it is preferable that the length of the path in which the carriers move is equal to or greater than 50 times the grain size.

On the other hand, if the grain size is too small, the characteristics (for example, the mobility of carriers) of the semiconductor material as a whole are inferior, so that the grain size should preferably be at least 150 nm.

Of course, even when the grain size is smaller than this value, the relationship between the length of the travel path of the carriers and the grain size is useful in reduction of the variation of the characteristics of the elements and in rendering the elements uniform.

A semiconductor layer having a mean grain size of or below approximately 300 nm is easily made. It can be satisfactorily realised and controlled by evaporation in ultra-high vacuum, as described later.

If the length of the travel path of carriers (in, for example, a field effect transistor, this length corresponds to the channel length) is determined in the circuit design of a semiconductor device in advance, the polycrystal grain size is adjusted. On the other hand, if the grain size is limited by any restriction on the conditions of forming the polycrystalline layer, the elements and the circuit need to be designed in conformity with the limited grain size.

The length of the (travel path) ranging region of the carriers has no upper limit in theory, but it will be at most 100 μm in practice. In addition, although the lower limit of the grain size is difficult to set specifically, the mobility of the carriers can be secured with grain sizes of at least 10 nm in practice. Accordingly, the ratio between the length of the travel path of the carriers and the grain size may be 10000 or so at its upper limit in practice.

The thickness of the semiconductor layer is preferably at least 100 nm because a channel may be formed in the layer. A thickness of at least 500 nm is more preferred.

Useful as the substrate is an amorphous or polycrystalline substrate such as a glass or ceramics substrate. One factor is price. Particularly the glass substrate is inexpensive. Furthermore, it is possible to use a light-transmitting substrate.

It is preferred in order to obtain semiconductor devices of slight variation, that the ratio ($C_{sub}/C_{semi}$) between the coefficient of thermal expansion ($C_{sub}$) of the substrate and the coefficient of thermal expansion ($C_{semi}$) of the semiconductor material is within the range 0.3 to 3.0. Although the details of the physical reasons are not clear, this requirement derives from the stressed state of the semiconductor layer attributed to the difference of the coefficients of thermal expansion of the substrate and the semiconductor layer.

A preferred method of evaporating a suitable polycrystalline semiconductor layer is now described.

The vacuum evaporator used is capable of attaining ultra-high vacuum, and may be a conventional evaporator having an ultra-high vacuum device. The degree of vacuum during the evaporation is kept below $1 \times 10^{-8}$ Torr. Particularly $O_2$ present in the residual gas during the evaporation has bad effects on the characteristics obtained, so that the partial pressure of oxygen is kept below $1 \times 10^{-9}$ Torr.

The evaporation rate is in the range 100 nm/hour to 1000 nm/hour.

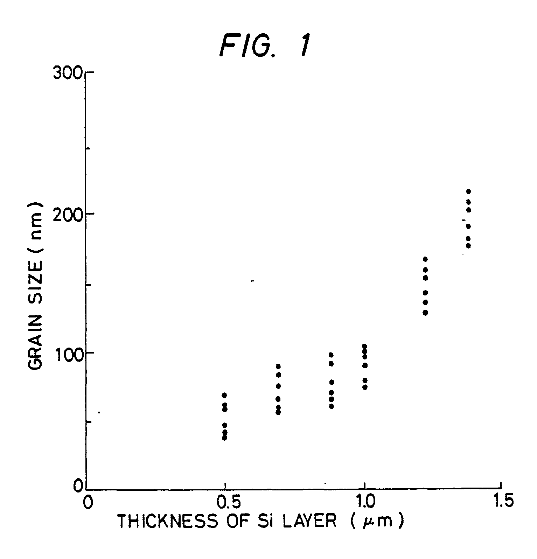

Control of the grain size can be accomplished by controlling one or more of the thickness of the evaporated layer, the temperature of the substrate, the rate of evaporation and the degree of vacuum. Figure 1 is a graph showing the relationship between the thickness of an evaporated silicon layer and the mean grain size thereof, the layer having been evaporated under the conditions of a substrate temperature of 600°C, an evaporation rate of 5000 Å/hour and a degree of vacuum during evaporation of $8 \times 10^{-9}$ Torr. The thickness of the layer was measured with a quartz oscillator.

In some cases, the grain size may be controlled by such techniques as laser annealing.

In order to fabricate a semiconductor device by processing a polycrystalline silicon layer, several manufacturing steps must be performed. The heat-treatment temperatures in these steps should be kept below 820°C which is the softening point of very hard glass, in order that the advantages obtainable with the present invention can be fully exploited. If employing a glass substrate of low softening point, the heat-treatment temperatures should be kept still lower, for example, below 550°C. In the following, there will be exemplified a case where a MOS field effect transistor is formed on a glass substrate of low softening point.

In producing a gate insulator, the technique of thermal oxidation of a silicon substrate is ordinarily used. Since, however, this thermal oxidation requires a temperature of at least 1000°C, it cannot be used here. In this example, $SiH_4$ and $O_2$ are reacted at a temperature of 300°C to at most 500°C, or $SiH_4$ and $NO_2$ are reacted at a temperature of 400°C to at most 800°C, to form an $SiO_2$ film by chemical vapor deposition. This $SiO_2$ film is used as the gate insulator.

To form a source region and a drain region, the method of forming $p^+$ layers or $n^+$ layers by thermal diffusion has hitherto usually been performed, but this requires a heat treatment at about 1150°C and cannot be used for the present purpose of forming a transistor on a glass substrate of low softening point. In the present embodiment thermal diffusion is replaced by the method of forming $p^+$ layers or $n^+$ layers by ion implantation. After ion implantation, a heat treatment for electrical activation is performed, in which the temperature needs to be kept lower than the softening point of the substrate used. Therefore, there is adopted, for example, a method in which ions such as $BF_2^+$ permitting high activation through a heat treatment at a low temperature of about 550°C are implanted, or a method in which, after ions such as $B^+$ are implanted, a heat treatment is performed at a temperature of about 500°C—600°C immediately before the reverse annealing effect takes place. With $P^+$ ions, $As^+$ ions etc., the reverse annealing effect is not so remarkable as in the case of the $B^+$ ions, but such impurities can be satisfactorily activated by heat treatment at about 500°C—600°C. Accordingly, both a $p^+$ and an $n^+$ layer can be formed by a low-temperature process at about 500°C—600°C. When employing a substrate, such as a very hard glass, whose softening point is higher than 800°C, there may of course be used a heat treatment at 800°C.

3

**0 073 603**

By the manufacturing method described above, the semiconductor layer can be made large in area or elongate, and a semiconductor material having a carrier mobility of at least 1 cm²/V sec can be produced.

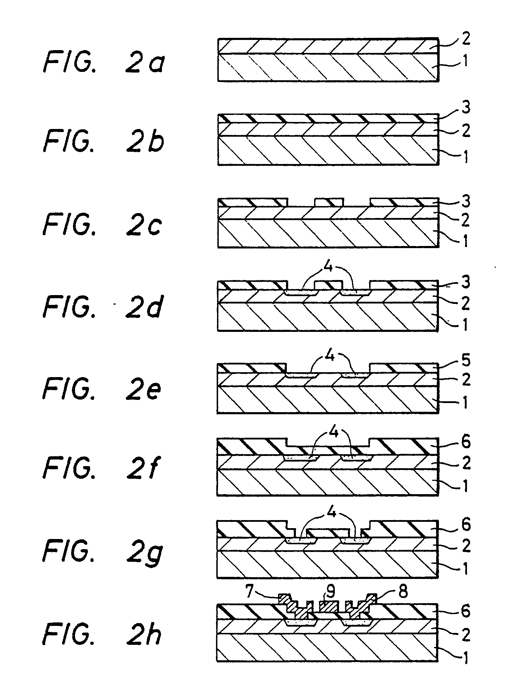

Referring to sectional views of Figures 2a—2h which illustrate the steps of manufacture, there will be described as an embodiment of the invention, the fabrication of an n-channel MOS field effect transistor in which a polycrystalline silicon layer is formed on a glass substrate and a channel is provided in the surface layer of the polycrystalline silicon layer.

First, the substrate is placed within a vacuum evaporator which can achieve ultra-high vacuum. The evaporator may be a conventional one. On the glass substrate 1 (aluminosilicate glass; coefficient of thermal expansion=$32\times10^{-7}$/°C) a silicon layer 2 is deposited to a thickness of 1.5 μm by vacuum evaporation under the conditions of a substrate temperature of 600°C, a degree of vacuum during evaporation of $8\times10^{-9}$ Torr and an evaporation rate of 5000 Å/hour (Figure 2a). The silicon layer 2 formed is of p-type polycrystalline silicon which is slightly doped with boron and which has a grain size of about 2000 Å and a carrier mobility of about 2 cm²/V sec. The coefficient of thermal expansion of this silicon layer is about $25\times10^{-7}$/°C (300°K).

Subsequently, an $SiO_2$ film 3 is deposited to a thickness of 5000 Å by vapor growth at a substrate temperature of 400°C (figure 2b). Next, as shown in Figure 2c, the $SiO_2$ film 3 is provided with windows for source and drain regions. The gap between the source region and the drain region is made 20 μm, so that the channel length of the MOS field effect transistor is also 20 μm. Subsequently $P^+$ ions having energy of 100 keV are implanted at a dose of $1\times10^{16}$/cm², and the resultant substrate is heat-treated in an $N_2$-atmosphere at 600°C for 30 minutes, whereby $n^+$ layers 4 are formed in the source and drain regions (Figure 2d).

At the next step, as shown in Figure 2e, the $SiO_2$ is removed with a field oxide film 5 left behind. An $SiO_2$ film 6 is deposited as a gate oxide film to a thickness of 7500 Å by chemical vapor deposition (Figure 2f) and electrode contact holes are provided as shown in Figure 2g by photoetching. After Al has been evaporated onto the whole surface, it is processed by photoetching to form a source electrode 7, a drain electrode 8 and a gate electrode 9 (Figure 2h). Thereafter, the product is heat-treated in an $H_2$-atmosphere at 400°C for 30 minutes.

By these steps, a thin-film MOS field effect transistor with the structure in which the channel 20 μm long is provided in the surface layer of the polycrystalline silicon layer has been fabricated. This semiconductor device exhibits good and stable transistor characteristics.

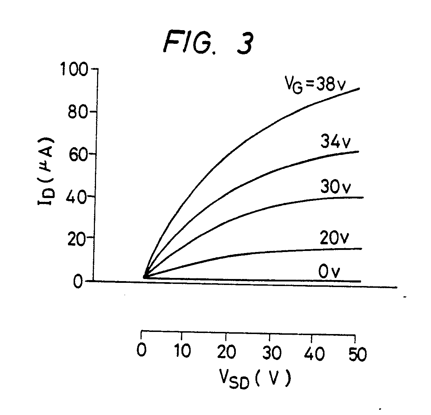

Figure 3 shows an example of the characteristic, at room temperature, of a MOSFET which was manufactured in this way by way of trial. The characteristic shown is the drain current $I_D$-versus-drain voltage $V_{DS}$ characteristic with a parameter being the gate voltage $V_G$.

In this example, the grain size is approximately 200 nm with respect to the channel length of 20 μm. Accordingly, a sufficiently large number of crystal grains exist in the travel direction of carriers, and the carriers are each influenced by a large number of grain boundaries. Consequently, when a large number of elements are manufactured, their characteristics become uniform.

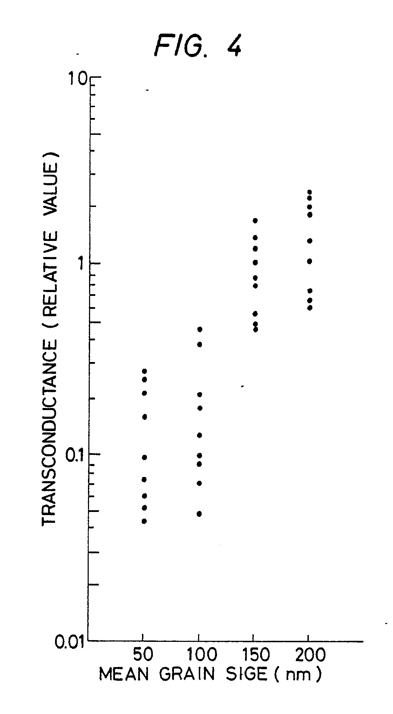

Silicon layer having various mean grain sizes were formed, and semiconductor devices similar to that described above were manufactured. The transconductances of the devices were compared, and the results are illustrated in Figure 4, in which the transconductances are given relative to the typical value of the transconductance of a layer having a grain size of 150 nm which is made unity. It will be seen that when the mean grain size is less than 150 nm, the transconductance is reduced sharply.

MOS field effect transistors having various gate lengths were manufactured using semiconductor layers whose mean grain sizes were 150 nm, 200 nm and 300 nm, and the (dispersion) variations in each case of the transconductances of the transistors were tested. When the ratio of the travel distance of carriers to the mean grain size was below 10 times, a dispersion on the order of ($^{+3}_{-1}$) was exhibited with respect to transconductance (relative value)=1. The condition of transconductance=0 signifies that operation is, in effect, impossible.

On the other hand, when the ratio of travel distance to mean grain size was 10 times to 50 times, the dispersion was of the order of ±0.7 to ±0.8, and when this ratio exceeded 50 times, the dispersion was of the order ±0.3 to ±0.4. Even when the ratio was approximately 200 times to 1000 times, the dispersion of the order of ±0.3 to ±0.4.

Similar MOS field effect transistors were manufactured using various substrates, and their transconductances ($g_m$) were measured. The results are listed in Table 1. In the manufacture, heat treatments were carried out at temperatures not higher than 500°C. With quartz glass or soda-lime glass, no transistor having good characteristics can be produced. The ratio between the coefficients of thermal expansion of the substrate and the semi-conductor layer placed thereon should preferably be set within predetermined limits, as discussed above.

4

TABLE 1

| Substrate | Coefficient of thermal expansion of substrate (0 to 300°C)×10⁻⁷) | Ratio = $\dfrac{Co(Sub)}{Co(Semi)}$ | $g_m$ ($V_G=10V$) |
|---|---|---|---|
| quartz glass | 5.5 | 0.22 | 1 to 9 μs |
| boro-silicated glass (I) | 32 | 1.28 | 10 to 50 μs |
| boro-silicated glass (II) | 46 | 1.84 | 10 to 100 μs |
| boro-silicated glass (III) | 50 | 2.0 | 10 to 100 μs |
| alumino-silicate glass | 54 | 2.16 | 10 to 100 μs |
| soda-lime glass (I) | 87 | 3.48 | — |
| soda-lime glass (II) | 94 | 3.76 | — |

## Claims

1. A polycrystalline thin-film transistor wherein a polycrystalline silicon layer (2) is formed on a substrate (1), the polycrystalline silicon layer (1) including at least a pair of electrode regions (4) for causing carriers to migrate, and there being means (7, 8, 9) for controlling the carriers characterized in that the length of the region in which the carriers migrate is at least ten times greater than the mean grain size of the polycrystalline silicon in the general migration direction of the carriers, the said mean grain size in at least the said region in which the carriers migrate being not less than 150 nm.

2. A polycrystalline thin-film transistor according to claim 1, wherein the said length of the region in which the carriers migrate is at least 50 times greater than the said mean grain size in the general migration direction of the carriers.

3. A polycrystalline thin-film transistor according to claim 1 or claim 2 wherein the ratio between the coefficients of thermal expansion of the substrate and of the polycrystalline silicon layer is in the range 0.3 to 3.0.

4. A polycrystalline thin-film transistor according to any one of claims 1 to 3 wherein said polycrystalline silicon layer is a polycrystalline film formed by vacuum evaporation in ultra-high vacuum.

5. A semiconductor integrated circuit including a plurality of transistors according to any one of claims 1 to 4 included in a single said polycrystalline layer (2).

6. A display device including a semiconductor integrated circuit according to claim 5.

## Patentansprüche

1. Polykristalliner Dünnfilm-Transistor, bei dem eine polykristalline Siliciumschicht (2) auf einem Substrat (1) ausgebildet ist, die polykristalline Siliciumschicht (1) wenigstens ein Paar von Elektrodengebieten (4) aufweist, um Ladungsträger zur Wanderung zu veranlassen, und eine Vorrichtung (7, 8, 9) zum Steuern der Ladungsträger vorhanden ist, dadurch gekennzeichnet, daß die Länge des Gebietes, in dem die Ladungsträger wandern, wenigstens zehnmal größer ist als die mittlere Korngrenze des polykristallinen Siliciums in der allgemeinen Wanderungsrichtung der Ladungsträger, wobei die mittlere Korngröße wenigstens in diesem Gebiet, in welchem die Ladungsträger wandern, nicht kleiner als 150 mm ist.

2. Polykristalliner Dünnfilm-Transistor nach Anspruch 1, bei dem diese Länge des Gebietes, in dem die Ladungsträger wandern, wenigstens 50 Mal größer ist als die mittlere Korngröße in der allgemeinen Wanderungsrichtung der Ladungsträger.

3. Polykristalliner Dünnfilm-Transistor nach Anspruch 1 oder 2, bei dem das Verhältnis zwischen dem thermischen Ausdehnungskoeffizienten des Substrates und der polykristallinen Siliciumschicht im Bereich zwischen 0,3 bis 3,0 liegt.

4. Polykristalliner Dünnfilm-Transistor nach einem der Ansprüche 1 bis 3, bei dem die polykristalline Siliciumschicht ein polykristalliner Film ist, der durch Vakuumverdampfung im Ultrahochvakuum gebildet ist.

5. Integrierte Halbleiterschaltung mit einer Anzahl von Transistoren nach einem der Ansprüche 1 bis 4, die in einer einzelnen polykristallinen Schicht (2) enthalten sind.

6. Anzeigevorrichtung, die eine integrierte Halbleiterschaltung nach Anspruch 5 enthält.

**Revendications**

1. Transistor à couche mince polycristalline, dans lequel une couche de silicium polycristallin (2) est formée sur un substrat (1), la couche de silicium polycristallin (1) contenant au moins un couple de régions d'électrodes (4) destinées à provoquer une migration de porteurs, et des moyens (7, 8, 9) étant prévus pour commander les porteurs, caractérisé en ce que la longueur de la région, dans laquelle les porteurs migrent, est au moins dix fois supérieure à la taille moyenne des grains du silicium polycristallin dans la direction générale de migration des porteurs, ladite taille moyenne des grains dans au moins ladite région, dans laquelle les porteurs migrent, n'étant pas inférieure à 150 nm.

2. Transistor à couche mince polycristalline selon la revendication 1, dans lequel ladite elongueur de la région, dans laquelle les porteurs migrent, est au moins 50 fois supérieure à la taille moyenne des grains dans la direction générale de migration des porteurs.

3. Transistor à couche mince polycristalline selon la revendication 1 ou 2, dans lequel le rapport entre les coefficients de dilatation thermique du substrat et de la couche de silicium polycristallin se situe dans la gamme allant de 0,3 à 3,0.

4. Transistor à couche mince polycristalline selon l'une quelconque des revendications 1 à 3, dans lequel ladite couche de silicium polycristallin est une pellicule polycristalline formée par évaporation sous vide, dans un vide très poussé.

5. Circuit intégré à semiconducteurs contenant une pluralité de transistors selon l'une quelconque des revendications 1 à 4, contenus dans une couche polycristalline (2) unique.

6. Dispositif d'affichage contenant un circuit intégré à semiconducteurs selon la revendication 5.

## FIG. 1

FIG. 2a

FIG. 2b

FIG. 2c

FIG. 2d

FIG. 2e

FIG. 2f

FIG. 2g

FIG. 2h

# FIG. 3

FIG. 4